# EUROPEAN PATENT SPECIFICATION

(11) **EP 1 814 955 B1**
(45) Date of publication and mention of the grant of the patent: **07.03.2012**
(21) Application number: 05809303.0
(22) Date of filing: 18.11.2005
(51) Int. Cl.: C09D 163/00, G03C 5/00, H05K 1/00

(54) **RESIN CURED FILM FOR FLEXIBLE PRINTED WIRING BOARD AND PRODUCTION PROCESS THEREOF**
AUSHÄRTBARE HARZFOLIE FÜR FLEXIBLE SCHALTKREISPLATINE UND HERSTELLUNGSVERFAHREN DAFÜR
FILM DE RÉSINE DURCI POUR CARTE À CIRCUIT IMPRIMÉ SOUPLE ET SON PROCÉDÉ DE FABRICATION

(30) Priority: 19.11.2004 JP 2004336357
(43) Date of publication of application: 08.08.2007
(73) Proprietor: Showa Denko K.K., Tokyo 105-8518 (JP)
(72) Inventor: INOUE, Hirofumi, Showa Denko K.K., Kawasaki-shi, Kanagawa 2100867 (JP)
(74) Representative: Strehl Schübel-Hopf & Partner
(86) International application number: PCT/JP2005/021628
(87) International publication number: WO 2006/054791

(56) References cited:
- WO-A-2004/110114
- WO-A-2005/116760
- US-A- 3 834 910
- US-A- 5 194 365
- US-A- 5 691 006

## Description

### Technical Field

The present invention relates to a cured (or hardened) insulating film of photocurable and thermosetting resin, formed on a flexible printed wiring (or printed-circuit) board after the formation of tin plating substantially containing no copper for an electronic component, and which can be formed by curing under a preferable condition (for example, at a temperature condition capable of inhibiting whisker growth), a flexible printed wiring board having such a film, and a process for producing the resin cured film.

### Background Art

Recently, along with the tendency of weight reduction, thickness reduction, length reduction and miniaturization in the field of electronic devices, there have been used a larger number of flexible printed wiring boards for electronic mounting and/or packaging. In the technical field of the flexible circuit board, along with the miniaturizing of electronic components, a further improvement in the density of electronic components is required, and there have been used a number of resin cured films of photocurable and thermosetting resins, using a resin (an ultraviolet-set resin, for example) by which a fine patterning can be obtained.

On the flexible printed wiring board, tin may generally be plated to improve the wettability of a solder and to prevent a conductor pattern from being oxidized.

As a process for forming a printed wiring board having provided thereon with tin plating, tin is plated after a insulating resin cured film is provided on a circuit board having formed thereon a copper circuit. In the method, during the plating process, a plating solution penetrates from the edge of the resin cured film to the bottom surface of the resin cured film along the wiring pattern to form a local cell so that copper in that part tends to be solved out. Additionally, when such a flexible circuit board is bent, the stress is concentrated in the solved-out part and the circuit is broken.

In order to solve the problem, a method is proposed in which a resin cured film is formed on a circuit board having covered with very thin tin plating, and then tin is plated again (JP-A (Japanese Unexamined Patent Publication; KOKAI) 2001-144145; Patent Document 1). However, in this method, during the plating process, the plating composition penetrates from the coat surface, and the color of the resin cured film is changed or the electrical reliability for a long time is easily degraded.

In other method, a insulating resin cured film is formed on a circuit board having coated on both surfaces thereof with tin plating. If tin plating is left after plating, needle crystals (whiskers) of tin are grown by an internal stress of an electroconductive pattern material to short adjacent patterns. Therefore, in general, it may be necessary to treat the circuit board by heat after plating to inhibit whiskers. When a insulating resin cured film is formed on a circuit board with tin plating, the temperature conditions during thermosetting and to inhibit whisker growth are not necessarily identical. Accordingly, if the film is heat-treated in one temperature condition, the other effect can not be obtained sufficiently.

Under these circumstances, a process for forming a printed wiring board using a resin composition which can be cured in a heating condition to inhibit whisker growth was proposed. However, in the method, because a thermosetting resin was used for a circuit insulating film, it was difficult to form a circuit board having mounted thereon a fine electronic component (JP-A 6-342969; Patent Document 2).

In particular, as an insulating film to provide a fine pattern, a photocurable and thermosetting resin cured film has been used. The prior resin cured film of photocurable and thermosetting resin might generally be needed to be cured by heat at 130 to 150 °C and for 30 to 60 minutes. Under the curing condition, because copper in a wiring part is dispersed in a pure tin plating layer, the plating layer becomes breakable. Accordingly, when the flexible printed wiring board is bent, there are problems that the plating layer in which copper is dispersed is ruptured and the circuit is broken. On the other hand, in a curing condition to inhibit whisker growth, 100 to 130 °C and for 60 to 150 minutes, a curing reaction does not sufficiently proceed and properties of a photocurable and thermosetting resin cured film are not good.
(Patent Document 1) JP-A 2001-144145
(Patent Document 2) JP-A 6-342969

WO 2005/116760 A1 discloses a photosensitive resin composition comprising an epoxy(meth)acrylate resin, a urethane (meth)acrylate resin, an epoxy resin, a diluent and a photopolymerization initiator and the use thereof for coating a printed circuit board.

US 5,194,365 discloses an image forming process comprising radiating a layer on a substrate, said layer being formed of a composition comprising a radical polymerizable resin such as an acrylic ester, a polymerization initiator, another radiation curable residue and a radiation-activated catalyst.

US 5,691,006 discloses water based photosensitive compositions comprising crosslinkable film-forming polymers, photopolymerizable acrylate and/or methacrylate monomers and photoinitiator compounds.

WO 2004/110114 A1 discloses a flexible wiring board comprising a layer of a cured thermosetting resin composition, wherein the cured thermosetting resin composition has a glass transition temperature of preferably 30-100 °C.

### Disclosure of Invention

An object of the present invention is to provide a flexible printed wiring board which has solved the above-mentioned problems encountered in the prior art.

Another object of the present invention is to provide a flexible printed wiring board, in which a circuit covered with tin plating is protected by a photocurable and thermosetting resin cured film and dispersion of copper to tin plating layer is decreased by curing at a temperature to inhibit whisker growth, which is low-cost and is stable.

As a result of earnest study for solving the above-mentioned problem, the present inventor has found that it is possible to obtain a flexible printed wiring board having thereon a resin cured film, which has been formed under a heat treatment condition of 100 to 130 °C, 60 to 150 minutes, so as to inhibit whisker, by using a resin cured film of photocurable and thermosetting resin for electronic component, having a glass transition temperature (hereinafter abbreviated as "Tg") of 80 °C or less in a flexible printed wiring board covered with tin plating substantially containing no copper.

The present invention may include, e.g., the following embodiments:
[1] An insulating resin cured film of photocurable and thermosetting resin formed on a flexible printed wiring board covered with a tin plating substantially containing no copper for an electronic component, the insulating resin cured film having a glass transition temperature of 80 °C or less after the curing thereof, wherein the insulating resin cured film has been formed via a thermosetting step at 100 to 130 °C for 60 to 150 minutes.
[2] The resin cured film of photocurable and thermosetting resin according to [1] , which is formed from a photocurable and thermosetting resin composition containing: (A) a photosensitive prepolymer having at least two unsaturated double bonds and at least one carboxyl group in one molecule, (B) an epoxy resin compound having at least two epoxy groups in one molecule and having a melting or softening point of 120 °C or less, (C) a photopolymerization initiator, and (D) a diluent.
[3] A process for producing a resin cured film of photocurable and thermosetting resin, wherein the resin cured film is formed by using the photocurable and thermosetting resin composition described in [2].
[4] A flexible printed wiring board, wherein a part or entirety of the board surface is covered with the resin cured film of photocurable and thermosetting resin according to [1] or [2].
[5] The flexible printed wiring board according to [4], wherein the tin plating substantially containing no copper has an average thickness of 0.05 to 1.0 µm.

The flexible printed wiring board of the present invention, obtained by using a photocurable and thermosetting resin cured film which can be cured at a temperature to inhibit whisker, can be obtained at a low cost, and has excellent properties and good flexibility. Therefore, the flexible printed wiring board of the present invention is particularly preferable to be used for an electronic device on which parts are aimed to be mounted in high density and for which flexibility is needed.

### Best Mode for Carrying Out the Invention

Hereinbelow, the present invention will be described in detail, with reference to the accompanying drawings as desired. In the following description, "%" and "part(s)" representing a quantitative proportion or ratio are those based on mass, unless otherwise specifically noted.

(Resin cured film of photocurable and thermosetting resin) The resin cured film of photocurable and thermosetting resin of the present invention is a resin cured film of photocurable and thermosetting resin covered on a flexible printed wiring board covered with tin plating substantially containing no copper for an electronic part, in which Tg after curing is 80 °C or less, wherein the resin cured film has been formed via a thermosetting step at 100 to 130 °C for 60 to 150 minutes.

If Tg of the resin cured film is over 80 °C, during forming a photocurable and thermosetting resin cured film, the activation of the molecules at a curing temperature of 100 to 130 °C is decreased as the curing by heat proceeds, and the curing reaction is inhibited. Therefore, heating for 150 or more minutes is necessary to obtain a resin cured film which provides properties required for a printed wiring board. It is not preferable that the thickness of a tin plating layer, in which copper is dispersed, becomes large, in such the long-time curing.

### (Preferable Embodiment of Cured Resin Film)

The resin cured film of photocurable and thermosetting resin of the present invention is not limited as long as the above described properties are satisfied. In view of photocurable or thermosetting property and easiness to be developed by an alkali, the resin cured film of photocurable and thermosetting resin of the present invention may preferably comprise a resin composition containing (A) a photosensitive prepolymer having at least two unsaturated double bonds and at least one carboxyl group in one molecule, (B) an epoxy resin compound having at least two epoxy groups in one molecule and having a melting or softening point of 120 °C or less, (C)a photopolymerization initiator, and (D)a diluent.

### (Photosensitive Prepolymer (A))

A photosensitive prepolymer (A) is a photosensitive prepolymer having, in one molecule, at least two ethylenically unsaturated double bonds and at least one carboxyl group. The photosensitive prepolymer is not particularly limited, but for example, a photosensitive prepolymer obtained by reacting a hydroxyl composition having a (meth)acyyloyl group and an urethane oligomer or polymer having an isocyanate group and a carboxyl group, such as an urethane oligomer or polymer obtained from a dihydroxy composition having a carboxyl group, a polyol composition whose number average molecular weight is 200 to 20,000 and a diisocyanate composition; a photosensitive prepolymer obtained by addition of an unsaturated or saturated multivalent carboxylic acid anhydride after an unsaturated mono carboxylic acid having an ethylenically unsaturated double bond is reacted with a polyfunctional epoxy resin having at least two epoxy groups in one molecule, a copolymer of an alkyl (meth)acrylate and a glycidyl (meth)acrylate, or a copolymer of a hydroxy alkyl (meth)acrylate, an alkyl (meth)acrylate and a glycidyl (meth)acrylate; a photosensitive prepolymer obtained by partially or completely reacting an oligomer or a polymer having a carboxyl group, such as a copolymer of an alkyl (meth)acrylate and a (meth)acrylic acid, with an unsaturated composition having, in one molecule, an ethylenenically unsaturated double bond and an epoxy group, such as a glycidyl (meth)acrylate; or a photosensitive prepolymer obtained by addition of an unsaturated or saturated multivalent carboxylic acid anhydride to the obtained photosensitive prepolymer.

An acid value of the photosensitive prepolymer (A) may preferably be in the range of 45 to 160 mgKOH/g. If the acid value of the photosensitive prepolymer is less than 45 mgKOH/g, it is difficult to develop by an alkali. On the other hand, if the acid value of the photosensitive prepolymer is more than 160 mgKOH/g, the hydrophilicity of the photosensitive prepolymer is so high that it is not preferable that the electric property is negatively affected. The photosensitive prepolymer (A) can be used singly or as a mixture of at least two prepolymers.

### (Epoxy Resin (B))

The epoxy resin (B) used in the present invention is an epoxy resin having at least two epoxy groups in one molecule and a melting or softening point of 120 °C or less. The epoxy resin is not particularly limited, and is an epoxy composition having at least two epoxy groups in one molecule and a melting or softening point of 120 °C, or less, for example, a bisphenol A-type epoxy resin, a hydrogerated bisphenol A-type epoxy resin, a brominated bisphenol A-type epoxy resin, a bisphenol F-type epoxy resin, a novolac-type epoxy resin, a phenol novolac-type epoxy resin, a cresol novolac-type epoxy resin, an N-glycidyl-type epoxy resin, a novolac-type bisphenol A epoxy resin, a chelate-type epoxy resin, a glyoxal-type epoxy resin, an epoxy resin containing an amino group, a rubber degenerated epoxy resin, a dicyclopentadienephenolic-type epoxy resin, a silicone degenerated epoxy resin, or an ε-caprolactone degenerated epoxy resin.

Additionally, as the epoxy resin (B), an epoxy resin, having inserted to the structure thereof a halogen such as chlorine or bromide, or an atom such as phosphorus, can be used to provide flame resistance. Further, a bisphenol S-type epoxy resin, a diglycidyl phthalate resin, a heterocyclic epoxy resin, a bixylenol-type epoxy resin, a biphenol-type epoxy resin and a tetra glycidyl xylenoylethane resin can be used.

If the melting or softening point of the component (B) in the photocurable and thermosetting resin composition of the present invention is more than 120 °C, the thermosetting temperature which is necessary to obtain a resin cured film having preferable property tends to be 130 °C or more. Therefore, it is not preferable that the tin plating layer in which copper is dispersed becomes thick and a copper wiring becomes breakable.

### (Photopolymerization Initiator(C))

The photopolymerization initiator (C) used in the present invention is not particularly limited. As the photopolymerization initiator(C), benzophenones such as benzophenone, benzoilbenzoic acid, 4-phenyl benzophenone, hydroxy benzophenone and 4,4'-bis(diethylamino)benzophenone; benzoin alkylethers such as benzoin, benzoin ethylether, benzoin isopropylether, benzoin butylether and benzoin isobutylether; acetophenones such as 4-phenoxydichloro acetophenone, 4-t-butyl-dichloro acetophenone, 4-t-butyl-trichloro acetophenone, diethoxy acetophenone and 2-benzyl-2-dimethylamino-1-(4-morpholinophenyl)-butanone-1; thioxanthenes such as thioxanthene, 2-chlorothioxanthene, 2-methylthioxanthene and 2,4-dimethylthioxanthene; alkyl anthraquinones such as ethyl anthraquinone and butyl anthraquinone; acylphosphine oxides such as 2,4,6-trimethylbenzoyl diphenylphosphine oxide; benzyldimethyl ketals such as 2,2-dimethoxy-1,2-diphenylethane-1-one; α-amino ketones such as 2-methyl-1-[4-(methylthio)phenyl]-2-morpholinopropane-1-one and 2-benzyl-2-dimethylamino-1-(4-morpholinophenyl)-butanone-1; α-hydroxy ketones such as 2-hydroxy-2-methyl-1-phenyl-propane-1-one, and 1-[4-(2-hydroxyethoxy)phenyl]-2-hydroxy-2-methyl-propane-1-one; and a 9,10-phenanthrene quinine can be exemplified. They can be used singly or as a mixture of at least two compounds.

The amount of the photopolymerization initiator (C) may preferably be 0.1 to 20 mass parts, and more preferably 0.2 to 10 mass parts, to 100 mass parts of total amount of photocurable compositions in the resin composition to obtain a flexible printed wiring board. If the mixing amount of the photopolymerization initiator (C) is less than 0.1 mass part, the photosensitive composition may not be sufficiently cured. On the other hand, if the amount is more than 20 mass parts, it is not preferable that the solvent resistance and the flexibility are degraded. The above described "photocurable composition" indicates a composition having a photopolymerizable functional group such as (meth)acrylate group, contained in the composition (A), the diluent(D) and the other components added according to necessity.

### (Photo Sensitizer)

In the present invention, if a polymerization curing is processed by ultraviolet lay using a photopolymerization initiator, a photo sensitizer may be used according to necessity to improve the polymerization speed. As a sensitizer used for such the object, pyrene, perylene, 2,4-diethyl thioxanthone, 2,4-dimethyl thioxanthone, 2,4-dichloro thioxanthone, and phenothiazine can be exemplified. The amount of the sensitizer may preferably be in the range of 0.1 to 100 mass parts to 100 mass parts of the photopolymerization initiator.

### (Diluent(D))

As the diluent(D) used in the present invention, as well as an organic solvent, a photopolymerizable monomer can be used as a reactive diluent doubling a solvent.

### (Organic Solvent)

Unless it goes against the object of the present invention, an organic solvent to be used is not particularly limited. As the organic solvent, ketones such as ethylmethyl ketone and cyclohexanone; aromatic hydrocarbons such as toluene, xylene and tetramethyl benzene; glycol ethers such as methyl cellosolve, butyl cellosolve, methyl carbitol, butyl carbitol, propyleneglycol monomethylether, dipropyleneglycol monoethylether, dipropyleneglycol diethylether and triethylene glycol monoethylether; esters such as ethyl acetate, butyl acetate, butyl cellosolve acetate and carbitol acetate; alcohols such as ethanol, propanol, ethylene glycol and propylene glycol; and aliphatic hydrocarbons such as octane and decane; petroleum solvents such as petroleum ether, petroleum naphtha, hydrogerated petroleum naphtha and solvent naphtha, can be exemplified.

### (Reactive Diluent)

On the other hand, as a photopolymerizable monomer which is a reactive diluent doubling a solvent, hydroxyalkyl (meth)acrylates such as 2-hydroxyethyl (meth)crylate and 2-hydroxypropyl (meth)acrylate; mono- or di(meth)acrylates of a glycol such as ethylene glycol, methoxy tetra ethylene glycol and polyethylene glycol; (meth)acrylamides such as N,N-dimethyl(meth)acrylamide and N-methylol(meth)acrylamide; amino alkyl(meth)acrylates such as N,N-dimethylamino ethyl (meth)acrylate; multivalent alcohols such as hexanediol, trimethylol propane, pentaerythritol, ditrimethylol propane, dipentaerythritol and tris-hydroxyethyl isocyanurate, or a multivalent (meth)acrylate of an ethylene oxide- or propylene oxide-adduct thereof; (meth)acrylates of an ethylene oxide- or propylene oxide-adduct of a phenol, such as phenoxyethyl (meth)acrylate and bisphenol A polyethoxy di(meth)acrylate; (meth)acrylates of glycidyl ethers such as glycerin diglycidylether, trimethylol propane triglycidylether and triglycidyl isocyanurate; ε-caprolactone degenerated (meth)acrylates such as caprolactone degenerated tris(acryloxyethyl) isocyanurate; and melamine (meth)acrylate, can be exemplified.

The above described diluent(D) can be used singly or as a mixture of at least two compounds according to necessity. The amount of the diluent is controlled so that the viscosity of the resin composition may preferably be 0.5 to 500 Pa·s, and more preferably 10 to 300 Pa·s. In the present specification, the viscosity indicates a value measured at 25 °C according to the rotation viscosity measuring method described in 4.5.3 of JIS K5400.

The content of the diluent in the resin composition to obtain a preferable flexible printed wiring board may preferably be 5 to 80 % by mass, and more preferably 10 to 70 % by mass (to 100 mass parts of the photosensitive prepolymer (A).

### (Additive, etc.)

A known curing agent, flame retardant, inorganic filler, organic filler, wax or surfactant can be further added to the resin composition to obtain a flexible printed wiring board of the present invention, in order to improve the properties such as heat resistance, flame resistance, hardness and flow property (such as thixotropy, viscosity, etc.). The total amount of the additives may preferably be not more than 200 mass parts to the photocurable and thermosetting resin component. If the amount is more than 200 mass parts, the original properties of the resin cured film, such as flexibility, are extremely degraded.

### (Curing agent)

The curing agent of the present invention improves the thermosetting property. As the curing agent, a known curing agent or curing accelerator can be exemplified, for example, imidazol derivatives such as 2MZ, 2E4MZ, C11Z, C17Z, 2PZ, 1B2MZ, 2MZ-CN, 2E4MZ-CN, C11Z-CN, 2PZ-CN, 2PHZ-CN, 2MZ-CNS, 2E4MZ-CNS, 2PZ-CNS, 2MZ-AZINE, 2E4MZ-AZINE, C11Z-AZINE, 2MA-OK, 2P4MHZ, 2PHZ and 2P4BHZ of Shikoku Chemicals Corp.; guanamines such as acetoguanamine and benzoguanamine; polyamides such as diaminodiphenyl methane, m-phenylenediamine, m-xylenediamine, diaminodiphenyl sulphone, dicyanediamide, urea, urea derivative, melamine and polybasic hydrazide; organic acid salts and/or epoxy adducts thereof; amine complexes of boron trifluoride; triazine derivatives such as ethyldiamino-S-triazine, 2,4-diamino-S-triazine and 2,4-diamino-6-xylyl-S-triazine; amines such as trimethyl amine, triethanol amine, N,N-dimethyl octyl amine, N-benzyl dimethyl amine, pyridine, N-methylmorpholine, hexa(N-methyl)melamine, 2,4,6-tris(dimethylaminophenol), tetramethyl guanidine and m-aminophenol; polyphenols such as polyvinyl phenol, polyvinyl phenol bromide, phenol novolac and alkyl phenol novolac; organic phosphines such as tributyl phosphine, triphenyl phosphine and tris-2-cyano ethyl phosphine; phosphonium salts such as tri-n-butyl (2,5-dihydroxyphenyl) phosphonium bromide and hexadecyltributyl phosphonium chloride; quaternary ammonium salts such as benzyltrimethyl ammonium chloride and phenyl tributyl ammonium chloride; anhydrides of the above poly basic acid; photocationic polymerization catalysts such as diphenyl iodonium tetrafluoro borate, triphenyl sulphonium hexafluoro antimonate, 2,4,6-triphenyl thiopyrylium hexafluoro phosphate, Irgacure 261 of Ciba-Geigy Ltd. and Optomer SP-170 of Asahi Denka Co., Ltd.; styrene-maleic acid anhydride resin; equimolal reactants of phenyl isocyanate and dimethyl amine; and equimolal reactants of dimethyl amine and an organic polyisocyanate such as trilene diisocyanate and isoholon diisocyanate.

### (Flame Retardant)

As a flame retardant, bromine-containing compounds such as brominated epoxy compounds, acid degenerated brominated epoxy compounds, brominated epoxy compounds having an acryloyl group and acid degenerated brominated epoxy compounds having an acyyloyl group; inorganic flame retardants such as red phosphorous, tin oxide, antimony compounds, zirconium hydroxide, barium metaborate, aluminum hydroxide and magnesium hydroxide; phosphorous compounds such as ammonium phosphate compounds, phosphate compounds, aromatic fused phosphates, halogen-containing fused phosphates, nitrogen-containing phosphorous compounds and phosphazene compounds, can be exemplified.

### (Inorganic Filler)

As an inorganic filler, a known inorganic filler can be used, for example, barium sulfate, barium titanate, silicon oxide powder, silicon oxide fine powder, crystalline silica, amorphous silica, talc, clay, magnesium carbonate, calcium carbonate, aluminum oxide, aluminum hydroxide or mica powder.

### (Organic Filler, etc.)

As an organic filler, a silicone resin, a silicone rubber and a fluorine resin can be exemplified. As a wax, a polyamide wax and a polyethylene oxide wax can be exemplified. As a surfactant, a silicone oil, a higher fatty acid ester and an amide can be exemplified.

### (Other Additive)

Further, according to necessity, a known additive can be used, for example, a known polymerization inhibitor such as hydroquinone, hydroquinone monomethylether, tert-butylcatechol, pyrogallol and phenothiazine; a known thickner such as silica, asbestos, orben, bentonite and montmorillonite; an antifoaming agent and/or a leveling agent such as a silicone, a fluorine, an acryl or a polymer; or an adhesiveness providing agent such as an imidazol, a thiazol, a triazol or a silane coupling agent. Additionally, as other additive, a UV protector, an elasticizer, etc., can be added for improving preservation stability in the range by which the object of the present invention is not detracted.

On the other hand, a known binder resin, for example, a copolymer of an ethylenically unsaturated compound such as an acrylic acid ester, or a polyester resin synthesized from a multivalent alcohol and a polybasic acid compound; and a photopolymerizable monomer or oligomer such as a polyester (meth)acrylate, a polyurethane (meth)acrylate and an epoxy (meth)acrylate, can be used in the range by which the properties as the resin composition are not degraded. The additive may be used as the above described reactive diluent.

### (Water)

Water can be added to decrease the inflammability of the resin composition to obtain the flexible printed wiring board of the present invention. If water is added, the component (A) may preferably be dissolved in water by forming a salt of the carboxyl group of the component (A) with an amine such as trimethyl amine or triethyl amine; or a (meth)acrylate compound having a tertiary amino group, such as N,N-dimethylaminoethyl(meth)acrylate, N,N-dimethylaminopropyl (meth)acrylamide, N,N-dimethyl (meth)acrylamide, acryloyl morpholine, N- isopropyl (meth)acrylamide or N-methylol acrylamide.

The resin composition to obtain the resin resin cured film for a flexible printed wiring board of the present invention can be obtained by uniformly mixing the above components by a general method. A mixing method is not particularly limited. A part of the components can be mixed and the remaining compositions can be mixed, or all the components can be mixed at once. As a mixing device, a known mixer such as a resolver, a roll mill or a bead mill can be used.

### (Embodiment of Production Process)

A process for producing the flexible printed wiring board is not particularly limited. As an embodiment of the producing method, for example, a part or entirety of a flexible printed wiring board, for an electronic component, covered with tin plating, substantially containing no copper, can be covered with a photocurable and thermosetting resin resin cured film, as described below. Thus, in such an embodiment, tin is plated with a thickness of 0.05 to 10 µm on a part or entirety of an electroconductive pattern of a copper foil, having a thickness of 5 to 35 µm, patterned on the film having a thickness of 12 to 125 µm. During the plating, the surface of the copper foil to be plated is cleaned by washing with a nonferrous metal surface detergent and by acid-treatment, and is subjected to tin plating with an electroless tin plating solution to form a substrate.

After washing and drying the substrate sufficiently with water or an acid solution, a photocurable and thermosetting resin composition is covered with a thickness of 5 to 160 µm by a screen printing method, a spraying method, a roll coating method, an electrostatic coating method, a curtain coating method, etc. The coat is dried at 60 to 100 °C for 5 to 60 minutes. The coat was exposed through a negative mask having thereon a desirable exposure pattern, a non-exposed part is developed and removed with an alkali developer, and the coat is washed by city water. After that, the coat is cured by heat at 100 to 130 °C for 60 to 150 minutes to manufacture a flexible printed wiring board, a part or entirety thereof is covered with a cured resin film.

In the above described method, because a washing process such as defatting during plating proceeds before a resin cured film is formed, the adhesion between the resin cured film and the substrate is not decreased, and the coat is not degraded by hydrolysis. On the other hand, because it is not necessary to consider influence on the resin cured film, the copper foil can be washed sufficiently. In order to improve adhesiveness of a photocurable and thermosetting resin composition, the plating surface can be washed sufficiently after plating. Additionally, because the resin cured film of photocurable and thermosetting resin is provided on a printed wiring board after plating, a plating solution cannot impregnate from the end of the resin cured film causing such as stain, scratch and lack of the film.

### (Tin Plating Layer)

The average thickness of the tin plating layer, substantially containing no copper, before forming a resin cured film of photocurable and thermosetting may preferably be in the range of 0.05 to 1.0 µm. If the average thickness of the tin plating layer is less than 0.05 µm, under a heat treating condition to inhibit whisker, copper is diffused in all the tin plating layers, the plating layer becomes breakable, and the plating layer, in which copper is diffused, tends to be broken easily when the flexible printed wiring board is bent. On the other hand, if the average thickness of the tin plating layer is more than 1.0 µm, the amount of tin is large and the producing cost tends to be higher.

### (Cured Resin Film Mainly Comprising Epoxy Resin)

To form a resin cured film of photocurable and thermosetting resin mainly comprising an epoxy resin, which is generally used today, it is generally necessary to heat at 130 to 150 °C for 30 to 60 minutes for thermosetting, although it depends on the specification of the product. Therefore, by using a photocurable and thermosetting resin composition which can be cured by heat at 100 to 130 °C, a heat treating temperature to generally inhibit whisker, for 60 to 150 minutes, the tin plating layer, substantially containing no copper, can be decreased by less than 0.3 µmin, in comparison with a prior method. If the tin plating layer is decreased by 0.3 µm or more, it is not preferable that the tin plating layer in which copper is diffused becomes thick, and that the plating layer in which copper is diffused becomes to be broken easily when a flexible printed wiring board is bent.

### (Active Light)

In the present invention, active light used for exposure is not particularly limited. As the active light, active light emitted from a known active light source, such as a carbon ark, a mercury vapor ark or a xenon ark, can be used. The sensitivity of the photopolymerization initiator (C) contained in the photosensitive layer may generally be maximum in the ultraviolet range. An active light source in the case may preferably emit ultraviolet ray effectively. If the photopolymerization initiator (C) is sensitive to visible light, such as 9,10-phenanthrene quinine, the visible light is used as active light, and a photographic flood lamp and a solar lamp can be used as a light source thereof, other than the above described active light sources.

### (Developer)

In the present invention, as a developer, an alkali solution such as potassium hydroxide, sodium hydroxide, sodium carbonate, potassium carbonate, sodium phosphate, sodium silicate, ammonia or an amine can be used.

Hereinbelow, the present invention will be described in more detail with reference to Examples. However, the present invention is not limited by the Example.

The commercial products, used in the following Example and comparative examples of the flexible printed wiring board of the present invention, are as follows.

### (Detergent)

(1) Neutra-clean 7L: a neutral immersion detergent (Rohm and Haas Electronic Materials)

### (Acid treating agent)

(1) Sulfuric acid 10% solution of sulfuric acid (a commercial chemical)

### (Electroless tin plating solution)

(1) LT-34: an electroless tin plating solution (Rohm and Haas Electronic Materials)

### (Photosensitive prepolymer-(A))

(1) PUA-1: an urethane (meth)acrylate resin (PUA-1) was manufactured as follows.

Into a reactor comprising an agitator, a thermometer and a condenser, 3750g (3mo1) of polycaprolactone diol (Daicel Chemical Industries, Ltd., PLACCEL212, molecular weight: 1250) as a polyol compound (e); 445g (3mo1) of dimethylol butanoic acid as a dihydroxyl compound (d) having a carboxyl group; 1554g (7mo1) of isoholondiisocyanate as a diisocyanate compound (g); 238g (2.05mo1) of 2-hydroxyethyl acrylate as a hydroxyl compound (f) having a (meth)acryloyl group; 1.0 g of p-methoxy phenol; and 1.0 g of di-t-butyl-hydroxy toluene were introduced. The mixture was heated to 60 °C while stirring, the heating was stopped, and 1.6 g of dibutyl tin dilaurate was added.

When the temperature in the reactor began to decrease, the mixture was heated again and was stirred at 80 °C. After confirming that the absorption spectrum (2280 cm⁻¹) of an isocyanate group was disappeared in the infrared absorption spectrum, the reaction was finished. Carbitol acetate was added as a diluent so that the solid content of the mixture is 50 % by mass, and an urethane (meth)acrylatate resin (hereinafter, abbreviated as PUA-1) having the viscosity of 10Pa·s(25 °C) was obtained. The weight average molecular weight of the obtained PUA-1 was 15,000, and the acid value of the solid content was 47 mgKOH/g.
(2) PUA-2: an urethane (meth) acrylate resin (PUA-2) was manufactured as follows.

By the same method for PUA-1 excluding using 2550g (3mol) of polytetramethylene glycol (Hodogaya Chemical Co., Ltd., PTMG-850, molecular weight: 850) as the polyol compound (e); 670g (5mol) of dimethylol propionic acid as the dihydroxyl compound (d) having a carboxyl group; 1776g (8mol) of isoholondiisocyanate as the diisocyanate compound (g); and 238g (= 2.05 mo1) of 2-hydroxyethyl acrylate as a (meth)acrylate having a hydroxyl group, and by adding carbitol acetate as a diluent so that the solid content is 45 % by mass, an urethane (methacrylate resin (hereinafter, abbreviated as PUA-2) having the viscosity of 26 Pa·s (25 °C) was obtained. The weight average molecular weight of the obtained PUA-2 was 16,000, and the acid value of the solid content was 90 mgKOH/g.
(3) ZFR-1401H: an epoxy acrylate prepolymer diluted with carbitol acetate (Nippon Kayaku Co., Ltd.), acid value of solid content: 100 mg·KOH/g, residue after heating: 65%.

### (Epoxy resin (B))

(1) YX-4000: a tetramethyl biphenol-type epoxy resin (Japan Epoxy Resin), epoxy equivalent: 185 g/eq., melting point: 105 °C,
(2) 1002: a bisphenol A-type epoxy resin (Japan Epoxy Resin),
   epoxy equivalent: 650 g/eq., softening point: 78 °C (Ring and ball method, with reference to JIS K7234-1986),
(3) 1009: a bisphenol A-type epoxy resin (Japan Epoxy Resin),
   epoxy equivalent: 3000 g/eq., softening point: 144 °C.

### (Photopolymerization initiator(C))

(1) IRGACURE907: 2-methyl-1-[4-(methylthio)phenyl]-2- morpholinopropane-1-one (Ciba Specialty Chemicals),
(2) DETX: 2,4-diethyl thioxansone (Nippon Kayaku Co., Ltd.)

### (Diluent (D))

(1) DPHA: 6 functional acrylate monomer (KAYARAD DPHA;Nippon Kayaku Co., Ltd.),
(2) UA-200AX: 2 functional urethane acrylate oligomer (Shin-nakamura Chemical Corp.),
(3) Carbitol acetate: Daicel Chemical Industries, Ltd.,
(4) #8500: a mixture of carbitol acetate and petroleum naphtha (Nippon Polytech Corp.)

### (Filler)

(1) Barium sulfate: Sakai Chemical Industry Co., Ltd.,
(2) Silica: AEROSIL, Nippon Aerosil Co., Ltd.

### (Curing agent)

(1) Dicyanediamide: Nippon Carbide Industries Co., Inc.

### (Preparation of photocurable and thermosetting resin composition)

The components in the mixing ratios (% by mass) shown in the following Table 1 were mixed using a 4-inch three rolls (Inoue Producing Co., Ltd.) at 23 °C, and a photocurable and thermosetting resin composition was prepared to obtain a flexible printed wiring board. The viscosity of the obtained composition was controlled to 23Pa·s by adding #8500. The viscosity was measured by the rotation viscosity measuring method described in 4.5.3 of JIS K 5400.

### (Manufacture of flexible printed wiring board)

A wiring pattern comprising a copper foil having the thickness of 12 µm was formed on a polyimide film. Tin plating layer having the thickness of 0.3 µm was formed on the whole surface of the wiring pattern.

A photocurable and thermosetting resin composition was coated on the circuit board, having the tin plating layer substantially containing no copper, by a screen printing method so that the thickness of the cured coating film was 18 to 23 µm, and was dried by a 70 °C hot-air dryer for 30 minutes. The coating film stood to cool to a room temperature, exposed by a metal halide lamp (0.5 J/cm², wavelength 365 nm conversion, spattering light), and then, was developed using a 1% by mass sodium carbonate solution at the solution temperature of 30 °C with the spray pressure of 2.0 MPa and for one minute. The coating film was washed by water of 30 °C with the spray pressure of 0.2 MPa and for one minute. The coating film was heat-treated using a hot-air drier under the heating condition exemplified in the Example and comparative examples to obtain a flexible printed wiring board.

### (Thickness of pure tin plating layer)

The thickness of the pure tin plating layer, substantially containing no copper, was measured using a Cocool film thickness measuring device (Densoku Instruments. Co., Ltd.). In the Cocool film thickness measuring device, a certain area of a tin plating layer is electrolyzed by dropping electrolyte, and the electrolysis stops when a layer containing impurities is exposed and the electricity is increased. The amount of solved tin is calculated from the amount of the electricity per unit area, and the thickness of the pure tin plating layer is calculated from the measured area and the specific gravity of tin. For the measuring method, a catalog and an instruction manual of Densoku Instruments. Co., Ltd. can be referred to, depending on necessity.

(Glass transition temperature (Tg)) The glass transition temperature (Tg) of the resin cured film of photocurable and thermosetting resin was measured using a thermomechanical analysis TMA (Seiko Instruments Inc., TMA6100). A sample piece used for the measurement was a resin cured film manufactured on a teflon sheet by the same method as of the flexible printed wiring board. The glass transition temperature is an intersection temperature of an extension of a lower-temperature side base line and a tangent line of a curve after glass transition.

### (Flexibility)

The obtained flexible printed wiring board was bent with the pressure of 0.5 MPa to 180 °. Occurrence of cracks of the resin cured film was observed by a microscope, and the flexibility was classified into the following three classes.
1: with no crack
2: with a few cracks
3: with many cracks
(Solvent resistance)

The obtained flexible printed wiring board was impregnated in isopropyl alcohol (IPA) of 23 °C. The surface of the resin cured film was observed with eyes and the solvent resistance was classified into the following three classes.
1: The resin cured film had no change.
2: The resin cured film was slightly swollen.
3: The resin cured film was swollen whitely, split or peeled.

The results of the above evaluation are shown in Table 1.

**[Table 1]**

| | | Examples | | | | | | Comparative examples | | |
|---|---|---|---|---|---|---|---|---|---|---|
| | | 1 | 2 | 3 | 4 | 5 | 6 | 1 | 2 | 3 |
| Mixing component | | % by mass | | | | | | % by mass | | |
| AD | PUA-1 | 50.0 | 40.0 | 50.0 | | | | | | |
| | PUA-2 | 15.0 | 15.0 | 15.0 | | | | | | |
| | ZFR-1401H | | | | 57.0 | 58.5 | 50.0 | 50.0 | 50.0 | 58.5 |
| B | YX-4000 | 7.0 | | | 10.5 | 12.0 | 8.0 | 8.0 | 8.0 | 12.0 |
| | 1002 | | 17.5 | | | | | | | |
| | 1009 | | | 17.5 | | | 17.5 | 17.5 | 17.5 | |
| C | IRGAQURE 907 | 5.0 | 5.0 | 5.0 | 5.0 | 5.0 | 5.0 | 5.0 | 5.0 | 5.0 |
| | DETX-S | 1.0 | 1.0 | 1.0 | 1.0 | 1.0 | 1.0 | 1.0 | 1.0 | 1.0 |
| D | #8500 | 1.5 | 2.0 | 2.0 | 4.0 | 3.0 | 2.0 | 2.0 | 2.0 | 3.0 |
| | DPHA | 2.0 | 1.0 | 1.0 | 2.0 | 8.0 | 1.0 | 1.0 | 1.0 | 8.0 |
| | UA-200AX | 8.0 | 8.0 | 8.0 | 8.0 | | 8.0 | | | |
| | Barium sulfate | 8.0 | 8.0 | 8.0 | 10.0 | 10.0 | 5.0 | 5.0 | 5.0 | 10.0 |
| | Silica | 1.5 | 1.5 | 1.5 | 1.5 | 1.5 | 1.5 | 1.5 | 1.5 | 1.5 |
| | Dicyaneamide | 1.0 | 1.0 | 1.0 | 1.0 | 1.0 | 1.0 | 1.0 | 1.0 | 1.0 |
| Hardening condition | Hardening temperature (°C) | 120 | 120 | 120 | 120 | 120 | 120 | 120 | 150 | 150 |
| | Hardening time (minute) | 90 | 90 | 90 | 90 | 90 | 90 | 90 | 30 | 30 |
| Features to be evaluated | Glass transition temperature Tg (°C) | 62.0 | 58.0 | 65.0 | 70.0 | 78.0 | 76.0 | 84.0 | 88.0 | 83.0 |
| | Thickness of tin plating layer before forming hardened film (µm) | 0.50 | 0.50 | 0.50 | 0.50 | 0.50 | 0.50 | 0.50 | 0.50 | 0.50 |
| | Thickness of tin plating layer after forming hardened film (µm) | 0.37 | 0.36 | 0.37 | 0.37 | 0.36 | 0.36 | 0.36 | 0.16 | 0.18 |
| | Flexibility | 1 | 1 | 1 | 1 | 2 | 1 | 3 | 3 | 2 |
| | Solvent resistance (IPA) | 1 | 1 | 2 | 1 | 2 | 2 | 2 | 1 | 1 |

## Claims

1. An insulating resin cured film of photocurable and thermosetting resin formed on a flexible printed wiring board covered with a tin plating substantially containing no copper for an electronic component, the insulating resin cured film having a glass transition temperature of 80 °C or less after the curing thereof, wherein the insulating resin cured film has been formed via a thermosetting step at 100 to 130 °C for 60 to 150 minutes.

2. The resin cured film of photocurable and thermosetting resin according to claim 1, which is formed from a photocurable and thermosetting resin composition containing: (A) a photosensitive prepolymer having at least two unsaturated double bonds and at least one carboxyl group in one molecule, (B) an epoxy resin compound having at least two epoxy groups in one molecule and having a melting or softening point of 120 °C or less, (C) a photopolymerization initiator, and (D) a diluent.

3. A process for producing a resin cured film of photocurable and thermosetting resin, wherein the resin cured film is formed by using the photocurable and thermosetting resin composition described in claim 2.

4. A flexible printed wiring board, wherein a part or entirety of the board surface is covered with the resin cured film of photocurable and thermosetting resin according to claim 1 or 2.

5. The flexible printed wiring board according to claim 4, wherein the tin plating substantially containing no copper has an average thickness of 0.05 to 1.0 µm.

## Patentansprüche

1. Isolierende aushärtbare Harzfolie aus lichthärtendem und wärmehärtendem Harz, gebildet auf einer flexiblen gedruckten Leiterplatte, die mit einer im wesentlichen kein Kupfer enthaltenden Zinnplattierung überzogen ist, für eine elektronische Komponente, wobei die isolierende aushärtbare Harzfolie eine Glasübergangstemperatur von 80°C oder weniger nach ihrem Härten aufweist und die isolierende aushärtbare Harzfolie über eine Wärmehärtungsstufe bei 100 bis 130°C während 60 bis 150 Minuten gebildet worden ist.

2. Aushärtbare Harzfolie aus lichthärtbarem und wärmehärtbarem Harz nach Anspruch 1, die aus einer lichthärtbaren und wärmehärtbaren Harzzusammensetzung gebildet ist, welche enthält: (A) ein lichtempfindliches Präpolymer mit mindestens zwei ungesättigten Doppelbindungen und mindestens einer Carboxygruppe in einem Molekül, (B) eine Epoxyharzverbindung mit mindestens zwei Epoxygruppen in einem Molekül und einem Schmelz- oder Erweichungspunkt von 120°C oder weniger, (C) einen Photopolymerisationsinitiator und (D) ein Verdünnungsmittel.

3. Verfahren zum Herstellen einer aushärtbaren Harzfolie aus lichthärtbarem und wärmehärtbarem Harz, wobei die aushärtbare Harzfolie durch Einsatz der lichthärtbaren und wärmehärtbaren Harzzusammensetzung nach Anspruch 2 gebildet wird.

4. Flexible gedruckte Leiterplatte, worin ein Teil oder die Gesamtheit der Plattenoberfläche mit der aushärtbaren Harzfolie aus lichthärtbarem und wärmehärtbarem Harz nach Anspruch 1 oder 2 überzogen ist.

5. Flexible gedruckte Leiterplatte nach Anspruch 4, wobei die im wesentlichen kein Kupfer enthaltende Zinnplattierung eine mittlere Dicke von 0,05 bis 1,0 µm aufweist.

## Revendications

1. Film de résine isolant cuit d'une résine photodurcissable et thermodurcissable formé sur une carte à câblage imprimé flexible recouverte d'un placage d'étain ne contenant pratiquement pas de cuivre pour un composant électronique, le film de résine isolant durci ayant une température de transition vitreuse inférieure ou égale à 80°C après son durcissement, où le film de résine isolant durci a été formé par une étape de thermodurcissement à une température comprise entre 100 et 130°C pendant 60 à 150 minutes.

2. Film de résine durci d'une résine photodurcissable et thermodurcissable selon la revendication 1, qui est formé à partir d'une composition de résine photodurcissable et thermodurcissable contenant : (A) un prépolymère photosensible ayant au moins deux doubles liaisons insaturées et au moins un groupe carboxyle dans une seule molécule, (B) un composé de résine époxy possédant au moins deux groupes époxy dans une seule molécule et ayant un point de fusion ou de ramollissement inférieur ou égal à 120°C, (C) une amorce de photopolymérisation, et (D) un diluant.

3. Procédé pour produire un film de résine durci d'une résine photodurcissable et thermodurcissable, dans lequel le film de résine durci est formé en utilisant la composition de résine photodurcissable et thermodurcissable décrite dans la revendication 2.

4. Carte à câblage imprimé flexible, dans laquelle toute ou partie de la surface de carte est recouverte par le film de résine durci d'une résine photodurcissable et thermodurcissable selon la revendication 1 ou 2.

5. Carte à câblage imprimé flexible selon la revendication 4, dans laquelle le placage d'étain ne contenant pratiquement pas de cuivre a une épaisseur moyenne comprise entre 0,05 et 1,0 µm.
